(19) **Europäisches Patentamt / European Patent Office / Office européen des brevets**

(11) **EP 4 621 433 A1**

(12) **EUROPEAN PATENT APPLICATION**

(43) Date of publication:
**24.09.2025 Bulletin 2025/39**

(21) Application number: **24165011.8**

(22) Date of filing: **21.03.2024**

(51) International Patent Classification (IPC):
**G01R 33/48** (2006.01)    **G01R 33/561** (2006.01)
**G01R 33/56** (2006.01)    **G01R 33/563** (2006.01)

(52) Cooperative Patent Classification (CPC):
**G01R 33/4822; G01R 33/561; G01R 33/5611;**
G01R 33/5608; G01R 33/5616; G01R 33/56341

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
• **Delattre-Klauser, Antoine**
  **1267 Coinsins (CH)**
• **Hilbert, Tom**
  **1006 Lausanne (CH)**

(74) Representative: **Palaci, Ismaël**
**Siemens Schweiz AG**
**Intellectual Property**
**Freilagerstrasse 40**
**8047 Zürich (CH)**

(54) **A METHOD AND SYSTEM FOR ACCELERATING MRI ACQUISITION**

(57)    The invention relates to a method (100) and an MRI system (200) for accelerating MRI acquisitions for imaging a biological object (210), the method comprising:
- acquiring (102) MRI data for a region of interest of the biological object;
- performing (103) an image reconstruction of said region of interest based on the acquired MRI data;
- outputting (104) the reconstructed image of said region of interest;

the method being characterized in that it comprises
- applying an undersampling pattern of a Cartesian k-space for acquiring said MRI data, wherein undersampled Cartesian acquisitions of MRI data are performed in three orthogonal readout directions, wherein readout lines are positioned along all three spatial orthogonal dimensions of a sampling grid of the Cartesian k-space.

## FIG 1

100

101 → 102 → 103 → 104

EP 4 621 433 A1

**Description**

**Technical Field**

The present disclosure is directed, in general, to Magnetic Resonance Imaging (MRI) techniques for imaging biological objects, like brain tissues, and more specifically, to the techniques for decreasing acquisition time in MRI.

**Background Art**

In contrast to other medical imaging modalities, MRI requires extended acquisition times owing to its inherent line-by-line scanning scheme across the Fourier domain (k-space). This need is further accentuated by the requirement for clinical exams to cover multiple imaging contrasts and therefore multiple successive acquisitions. Additionally, at ultra-high field MRI, the natural increase in SNR allows for acquisitions at higher resolution, but at the expense of even longer scan times. Therefore, the substantial demand for MRI exams with both high resolution and short acquisition time reveals the pressing need for efficient MRI acceleration methods. To decrease the time required for performing MRI, different solutions have been proposed. They are notably "parallel imaging", "compressed sensing", and "Non-Cartesian sampling".

Parallel imaging (PI) is based on the development of receiver coil arrays, where each coil element possesses its own sensitivity profiles. MRI scans acquired with receiver coil arrays exhibit considerable data redundancy and capture spatial information from individual coil elements. Parallel imaging techniques capitalize on this properties to strategically undersample the k-space in a systematic manner. MRI acquisitions following this regular undersampling patterns along the phase-encoded dimensions are accelerated accordingly by a factor 2,3 or 4. There is two main parallel imaging techniques, SENSE (Sensitivity Encoding) and GRAPPA (Generalized Autocalibrating Partial Parallel Acquisition). SENSE utilizes pre-determined coil sensitivity profiles to unfold the signal during image reconstruction, and GRAPPA extrapolates missing k-space points by leveraging the correlation between neighboring k-space points acquired with different coil elements.

Compressed sensing (CS) is an acceleration technique that relies on a random undersampling of the k-space. The phase-encoding dimensions of the k-space are undersampled following a random pattern that results in a pseudo random folding of the images along the phase-encoding directions. For accurate reconstruction ot the MRI images acquired with CS acceleration, a specific constrained reconstruction algorithm that relies on the natural sparsity of MRI images must be employed. CS usually accelerates image acquisition beyond the capabilities of traditional parallel imaging. However, compared to parallel imaging, the CS approach requires a longer image reconstruction time.

Non-Cartesian sampling employs trajectories like radial, spiral, or rosette, diverging from the regular Cartesian grid. These approaches may offer accelerated image acquisition by covering more spatial frequencies (k-space coordinates) within each trajectory compared to a single Cartesian readout, effectively minimizing the number of shots needed for a full image. This inherent efficiency translates to faster MRI acquisitions. Non-Cartesian trajectories can also be integrated with CS to achieve a random sampling pattern, often more optimal than Cartesian sampling due to their ability to undersample across all accessible spatial dimensions. Despite these advantages, non-Cartesian methods demand specialized gradient waveforms potentially introducing artifacts, lower imaging performance, and increasing complexity during inline image reconstruction.

The development and adoption of fast acquisition methods are crucial to ensure the timely delivery of detailed diagnostic insights while minimizing inconvenience for patients.

**Summary of Invention**

An objective of the present invention is to propose a method and a system for accelerating an MRI acquisition, and decreasing therefore the time required for performing such MRI acquisition.

Said objective is achieved according to the present invention by a method and a system for accelerating MRI acquisitions according to the object of the independent claims. Dependent claims present further advantages of the invention.

More precisely, the present invention concerns a method for accelerating an MRI acquisition for imaging a biological object by means of an MRI system, the method comprising:

- acquiring MRI data for a region of interest of the biological object;
- performing an image reconstruction of said region of interest based on the acquired MRI data. Typically, specific image reconstruction functions or equations are used for reconstructing the image of the region of interest based on the acquired MRI data;
- outputting the reconstructed image of said region of interest;

the method being characterized in that it comprises

- applying an undersampling pattern of the k-space (i.e. of the 3D Fourier domain) for acquiring said MRI data, wherein said k-space is a Cartesian k-space, wherein undersampled Cartesian acquisitions of MRI data are performed in three orthogonal readout directions, wherein readout lines are positioned along all three spatial dimensions of a sampling grid of the Cartesian k-space.

The present invention also concerns an MRI system configured for accelerating an MRI acquisition, the system being configured for carrying out the steps of the previously described method. Advantageously, the method and the system according to the invention enable to efficiently decrease the MRI data acquisition time for imaging said biological object while resulting in an accurate image of said biological object.

**Description of Embodiments**

The present invention may also comprise one or several MRI Cartesian sequences performed for said biological object, notably by said MRI system. Said one or several 3D MRI Cartesian sequences may comprise:

- an MPRAGE sequence; or
- an MP2RAGE sequence; or
- a SPACE sequence; or
- a SWI sequence; or
- a VIBE sequence; or
- a TOF sequence.

In particular, the image reconstruction uses a function or equation comprising an iterative optimizer based on:

- a gradient descent; and/or
- a split-algorithm; and/or
- an unrolled neural network.

Further, said iterative optimizer may comprise a regularization term based on

- Wavelet coefficient; and/or
- a total variation; and/or
- a low-rank approximation; and/or
- neuronal network layers.

Preferentially, said undersampling pattern of the k-space is a random or incoherent undersampling pattern, and said readout lines are randomly positioned along all three spatial orthogonal dimensions of the Cartesian k-space.

Preferentially, said image reconstruction uses a 3D CS reconstruction. For instance, said 3D CS reconstruction might be configured for applying the following equation for reconstructing said image:

$$\mathrm{m} = \arg\min_{m} \sum_{c,\omega} \left| d_{c,\omega} - F_\omega C_c m \right|_2 + \lambda |\Psi m|_1 \qquad \text{Eq. 1}$$

where

$\omega$ is an index running over said three orthogonal readout directions,
$c$ is indexing coil elements of an MRI apparatus configured for acquiring said MRI data,
$d_{c,\omega}$ is a 3D measured dataset of the k-space obtained from the orthogonal readout direction $\omega$ and coil element $c$,
$F_\omega$ is a forward encoding operator for the readout direction $\omega$, configured for encoding image data into the 3D measured dataset $d_{c,\omega}$,
$C_c$ is a coil sensitivity profile for the coil element c,
$|\Psi m|_1$ is the $L^1$-norm of a sparsity transform of the image m (e.g. $\Psi m$ is a 3D wavelet transform of the image m). $\lambda |\Psi m|_1$ represents the regularization term of the Eq. 1,
$|k|_2$ is the $L^2$-norm of k. It represents the consistency term of Eq. 1,
$\lambda$ is a regularization parameter promoting sparsity,
m is a 3D array representing the voxel intensity of the image.

Eq. 1 represents an optimization problem that is typically solved by an iterative optimizer, i.e. an algorithm configured for solving such equation.

Preferentially, the method according to the invention is configured for implementing an Echo-Planar imaging, wherein an undersampled EPI pattern is acquired in said three orthogonal directions. In such a case, an EPI pattern could be highly accelerated with either CS or PI, and acquired in said three orthogonal directions, with a simultaneous reconstruction of the three corresponding datasets for image reconstruction.

**Brief Description of the Drawing**

For a more complete understanding of the present disclosure, and the advantages thereof, reference is now made to the following descriptions taken in conjunction with the accompanying drawings, wherein like numbers designate like objects, and in which:

Fig. 1 illustrates a flowchart of a method for accelerating an MRI acquisition;

Fig. 2 schematically illustrates a preferred embodiment of an MRI system according to the invention;

Fig. 3 shows a graph representing single readout direction performed for known in the art CS;

Fig. 4 shows a graph representing an ABRICOTINE sampling pattern according to the invention;

Fig. 5 shows k-space sampling and PSF for known in the art CS shown in Fig. 3;

Fig. 6 shows k-space sampling and PSF for the ABRICOTINE sampling pattern according to Fig. 4.

**Description of Examples**

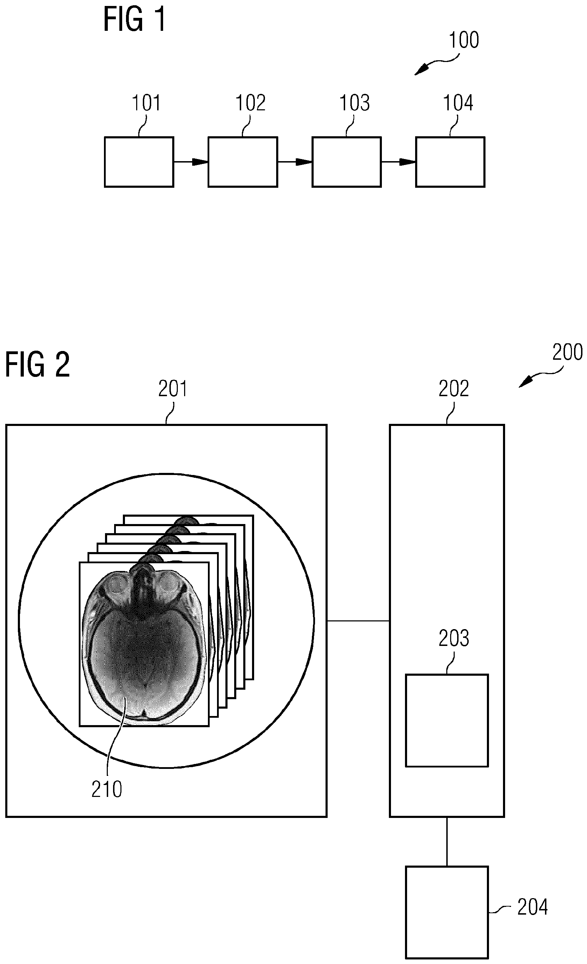

We will now describe in more detail a preferred embodiment of the method according to the invention through Figures 1 and 2, wherein Figure 1 describes the different steps of the method 100 carried out by a preferred embodiment of an MRI system 200 according to the invention which is illustrated by Figure 2.

The preferred embodiments illustrated in Fig. 1 and 2 will be described in the context of a random undersampling of the k-space, wherein sparsely undersampled Cartesian acquisitions of MRI data are performed in three orthogonal readout directions, wherein readout lines are randomly positioned along all three spatial dimensions of the Cartesian k-space, resulting in an improved random sampling of 3D Fourier domain for Cartesian CS. While said preferred embodiments are described in the context of random undersampling, they may as well work for coherent undersampling used for PI.

The MRI system 200 typically comprises a scanner 201 and a control unit 202. The latter might be configured for controlling the scanner 201 so that it performs MRI Cartesian sequences for imaging said biological object 210. The scanner 201 may comprise different coils and respective coil controllers configured for generating magnetic fields and RF pulses in order to acquire MRI data corresponding to an MRI signal induced in a receiver coil by the biological object 210, e.g. a brain under investigation. Said MRI signal is transmitted by the receiver coil controller to the control unit 202. Said MRI data acquired by the control unit 202 are then used for reconstructing an image of the biological object 210, in particular of a region of interest of said biological object (e.g. a specific region of the brain). The control unit 202 preferentially comprises a memory 203 and is connected to an interface, e.g. a display 204 for displaying images reconstructed from the acquired MRI data. Contrary to existing MRI systems, the MRI system 200 according to the invention is configured for implementing a very specific acquisition technique that will be best described through the following method steps.

At step 101, the MRI system 200 performs one or several MRI Cartesian sequences for imaging said biological object 210. For instance, a highly accelerated (AF = 10) high-resolution 3D MPRAGE sequence can be performed by the MRI system 200 for imaging said biological object.

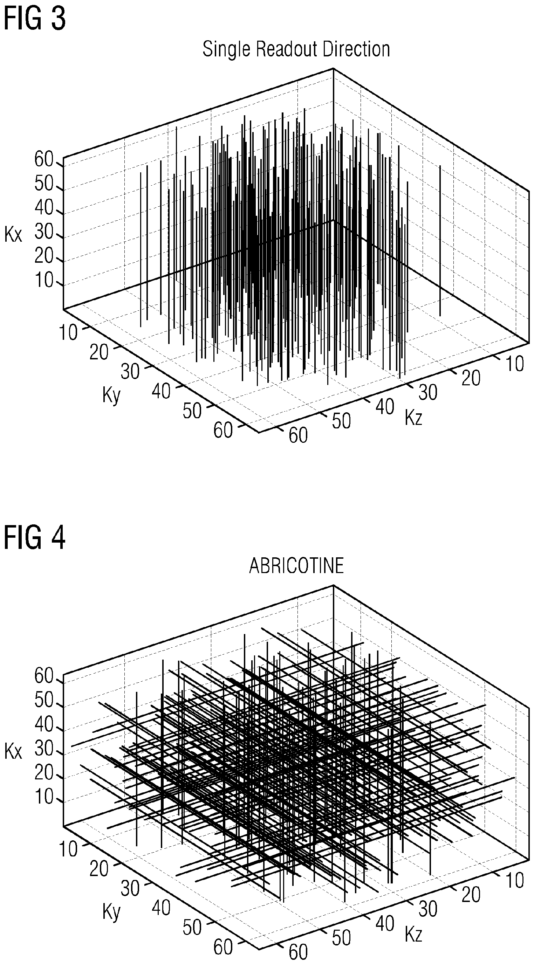

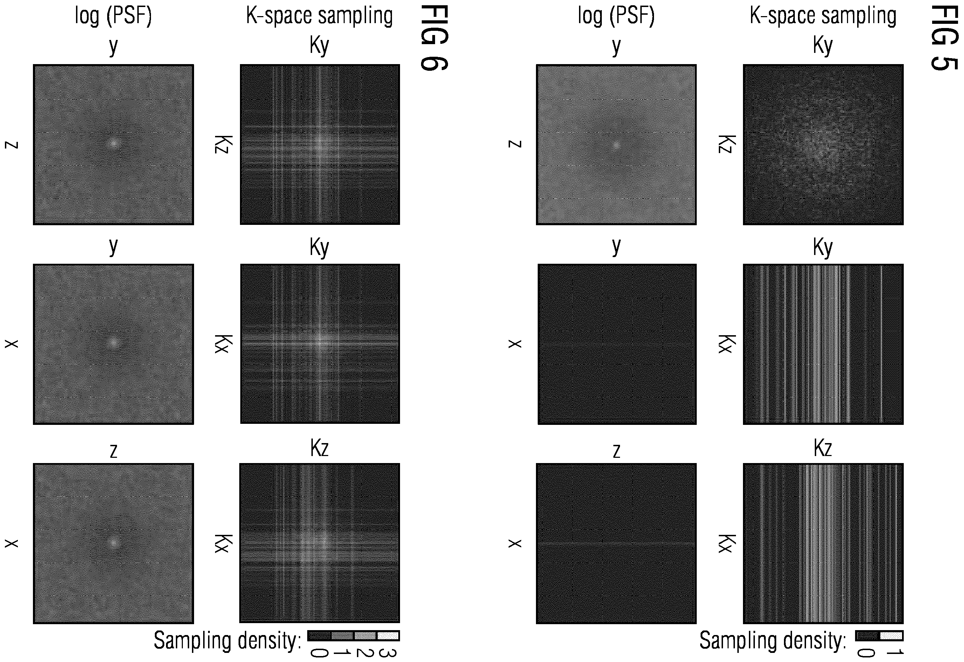

At step 102, the MRI system 200, notably via its control unit 202, acquires MRI data for a region of interest of the biological object. Contrary to existing acquisition techniques, the present acquisition requires an undersampling pattern of the Cartesian k-space, wherein acquisitions of undersampled Cartesian MRI data are performed in three different and orthogonal readout directions. The readout lines are positioned along all three spatial orthogonal dimensions of the Cartesian k-space sampling grid, the orthogonal readout directions alternating during said acquisitions. Preferentially, said undersampling is a random undersampling of the 3D Fourier domain for Cartesian CS. Advantageously, said undersampling introduces a novel 3D sparse sampling pattern, which will be named hereafter Alternating Basis Readout Imaging with Compressed-sensing with Three-DImensioNal Encoding, abbreviated "ABRICOTINE". Unlike single readout direction CS which is illustrated in Fig. 3 (all readouts are along the x-axis), ABRICOTINE incorporates randomly positioned readout lines along the three spatial dimensions, as shown in Fig. 4 (readouts are across all three Cartesian axes). The resulting 3D sampling pattern exhibits a more balanced distribution of sampling points across the 3D Fourier domain (k-space). This is illustrated in Figures 5 and 6, wherein the top raw of Figure 5, and respectively Figure 6, shows the k-space sampling density resulting for Figure 3, and respectively Figure 4, and the bottom raw represents the respective logarithm of the point spread function (PSF) for the used sampling pattern. The spreading of the PSF along the 3 dimensions illustrates the effect of the 3D undersampling with ABRICOTINE whereas the PSF spreads only along 2 dimensions with single readout direction CS. The ABRICOTINE provides thus improved reconstruction performances compared to single readout direction CS when the same total number of readout lines is acquired.

At step 103, the MRI system 200, in particular its control unit 202, performs an image reconstruction of the region of interest of the biological object 210 based on the acquired MRI data. Preferentially, the three sets of readout lines acquired with orthogonal directions according to the invention are subsequently merged into a single dataset and reconstructed at once. However, other ways of processing the data might be chosen by the skilled person. In the case of ABRICOTINE, the 3D sparse sampling may require for instance a 3D CS reconstruction that might be formulated with three distinct consistency terms $|d_{c,\omega} - F_{\omega}C_c m|_2$, each associated with a specific readout direction according to the value taken by $\omega$ in Eq. 1, wherein the sparsity required for an accurate image reconstruction is achieved by applying simultaneously the $L^1$-norm of the 3D wavelet coefficient ($\Psi m$) as constraint.

At step 104, the MRI system 200 may output the reconstructed image of said region of interest, for instance on a display 204.

The present invention presents several advantages compared to already existing MRI techniques. For instance, when implementing in the framework of ABRICOTINE, the present method is particularly efficient at high acceleration (i.e. acceleration factor > 6), offering a potential 25-30% of reduction in acquisition time compared to conventional CS technique, while preserving an equivalent image quality. Furthermore, the presented technique might reduce aliasing/-wrap around artifacts as well as flow artifacts. The improved acceleration performance is mainly due to the fact that at high acceleration, ABRICOTINE provides a better distribution of the sampling points across all three k-space dimensions, while traditional CS primarily focuses on undersampling in the phase-encoding plane, leading to the emergence of substantial gaps in the k-space for high acceleration. These gaps can pose challenges during the CS reconstruction process, potentially causing artifacts in the reconstructed images, which is avoided when using ABRICOTINE. In addition, with the ABRICOTINE acquisition scheme, phase and frequency-encoded directions are mixed and therefore attenuate artefacts present in phase-encoding directions.

To summarize, the present invention proposes to incorporate phase-encoding, notably sparse phase-encoding, in three orthogonal directions, in order to achieve true three-dimensional undersampling of the Fourier domain. Typically, the MRI system according to the invention is configured for performing three Cartesian acquisitions in orthogonal directions with phase-encoding undersampling and for integrating the latter into a single dataset used for reconstructing the image, notably based on Eq. 1. This technique enables to achieve significant enhancements of image quality when imaging a biological object, e.g. a brain, while decreasing the time required to perform MRI data acquisition.

**Claims**

1.  Method (100) for accelerating MRI acquisitions for imaging a biological object (210) by means of an MRI system (200), the method comprising:

    - acquiring (102) MRI data for a region of interest of the biological object;
    - performing (103) an image reconstruction of said region of interest based on the acquired MRI data;
    - outputting (104) the reconstructed image of said region of interest;

    the method being **characterized in that** it comprises

    - applying an undersampling pattern of a Cartesian k-space for acquiring said MRI data, wherein undersampled Cartesian acquisitions of MRI data are performed in three orthogonal readout directions, wherein readout lines are positioned along all three spatial orthogonal dimensions of a sampling grid of the Cartesian k-space.

2.  Method (100) according to claim 1, comprising performing (101) one or several MRI Cartesian sequences for said biological object.

3.  Method (100) according to claim 2, wherein said one or several MRI Cartesian sequences comprise:

- an MPRAGE sequence; or
- an MP2RAGE sequence; or
- a SPACE sequence; or
- a SWI sequence; or
- a VIBE sequence; or
- a TOF sequence.

4. Method (100) according to one of the claims 1 to 3, wherein said image reconstruction uses an equation comprising an iterative optimizer based on:

- a gradient descent; and/or
- a split-algorithm; and/or
- an unrolled convolutional network.

5. Method (100) according to claim 4, wherein said iterative optimizer comprises a regularization term based on:

- Wavelet coefficients; and/or
- a total variation; and/or
- a low-ranked method; and/or
- a convolutional neuronal network.

6. Method (100) according to one of the claims 1 to 3, wherein said undersampling pattern is a random or incoherent undersampling pattern of the k-space, the undersampled Cartesian acquisitions being sparse, and wherein said readout lines are randomly positioned along all three spatial orthogonal dimensions of the Cartesian k-space, and wherein said image reconstruction uses a 3D Compressed Sensing, hereafter "CS", reconstruction.

7. Method (100) according to claim 6, wherein said 3D CS reconstruction is configured for applying the following equation for reconstructing said image :

$$\text{m} = \underset{m}{\arg\min} \sum_{c,\omega} \left| d_{c,\omega} - F_\omega C_c m \right|_2 + \lambda |\Psi m|_1$$

where

$\omega$ is an index running over said three orthogonal readout directions,
$c$ is indexing coil elements of an MRI apparatus configured for acquiring said MRI data,
$d_{c,\omega}$ is a 3D measured data of the k-space obtained from the orthogonal readout direction $\omega$ and coil element $c$,
$F_\omega$ is a forward encoding operator for the readout direction $\omega$;
$C_c$ is a coil sensitivity profile for the coil element $c$,
$|\Psi m|_1$ is the $L^1$-norm of a sparsity transform of the image m, $|k|_2$ is the $L^2$-norm of k,
$\lambda$ is a regularization parameter promoting sparsity,
m is a 3D array representing the voxel intensity of the image.

8. Method (100) according to claim 7, wherein $|\Psi m|_1$ is the $L^1$-norm of $\Psi m$ that is the 3D wavelet transform, of the image m.

9. Method (100) according to claim 1, comprising implementing an Echo-Planar imaging, wherein an undersampled EPI pattern is acquired in said three orthogonal directions.

10. MRI system (200) configured for imaging a biological object (210), said MRI system (200) being configured for carrying out the steps of the method (100) according to one of the claims 1 to 9.

## FIG 1

## FIG 2

FIG 3

Single Readout Direction

FIG 4

ABRICOTINE

FIG 5

FIG 6

Europäisches
Patentamt

European
Patent Office

Office européen
des brevets

## EUROPEAN SEARCH REPORT

**Application Number**

EP 24 16 5011

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 145 924 B2 (SIEMENS HEALTHCARE GMBH [DE]) 4 December 2018 (2018-12-04) | 1,2,6,9,10 | INV. G01R33/48 |
| Y | * column 3 - column 4; claim 1; figures 13-18 * <br> * column 5, paragraph 2; claims 15,18 * | 3-5,7,8 | G01R33/561 G01R33/56 |
| Y | AURÉLIEN J TROTIER ET AL: "The Compressed Sensing MP2RAGE as a surrogate to the MPRAGE for neuro-imaging at 3T", PROCEEDINGS OF THE JOINT ANNUAL MEETING ISMRM-ESMRMB 2022 & ISMRT ANNUAL MEETING, LONDON, UK, 07-12 MAY 2022, ISMRM, 2030 ADDISON STREET, 7TH FLOOR, BERKELEY, CA 94704 USA, no. 1261, 22 April 2022 (2022-04-22), XP040727809, * the whole document * | 3 | ADD. G01R33/563 |
| Y | SANDINO CHRISTOPHER M ET AL: "Compressed Sensing: From Research to Clinical Practice With Deep Neural Networks: Shortening Scan Times for Magnetic Resonance Imaging", IEEE SIGNAL PROCESSING MAGAZINE, IEEE, USA, vol. 37, no. 1, 17 January 2020 (2020-01-17), pages 117-127, XP011767143, ISSN: 1053-5888, DOI: 10.1109/MSP.2019.2950433 [retrieved on 2020-01-17] * section "Unrolled CS"; page 120, paragraph 2 * | 4,5,7,8 | |

TECHNICAL FIELDS SEARCHED (IPC)

G01R

-/--

The present search report has been drawn up for all claims

| Place of search | Date of completion of the search | Examiner |
|---|---|---|
| Munich | 19 August 2024 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 24 16 5011

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | Klauser Antoine ET AL: "ABRICOTINE MRI: Enhancing Sparsity Across the Three Dimensions of the Fourier Domain in Cartesian Sampling", Online , 8 May 2024 (2024-05-08), pages 1-1, XP093195655, Internet Retrieved from the Internet: URL:https://submissions.mirasmart.com/ISMRM2024/ViewSubmissionTeaser.aspx [retrieved on 2024-08-16] * the whole document * ----- | | |

TECHNICAL FIELDS
SEARCHED      (IPC)

The present search report has been drawn up for all claims

| Place of search | Date of completion of the search | Examiner |
|---|---|---|
| Munich | 19 August 2024 | Skalla, Jörg |

EPO FORM 1503 03.82 (P04C01)

## ANNEX TO THE EUROPEAN SEARCH REPORT
## ON EUROPEAN PATENT APPLICATION NO.

EP 24 16 5011

This annex lists the patent family members relating to the patent documents cited in the above-mentioned European search report.
The members are as contained in the European Patent Office EDP file on
The European Patent Office is in no way liable for these particulars which are merely given for the purpose of information.

19-08-2024

| Patent document cited in search report | Publication date | Patent family member(s) | Publication date |
|---|---|---|---|
| US 10145924 B2 | 04-12-2018 | NONE | |

For more details about this annex : see Official Journal of the European Patent Office, No. 12/82

EPO FORM P0459